Europäisches Patentamt

European Patent Office

Office européen des brevets

(11) Veröffentlichungsnummer: **0 489 396 A1**

# EUROPÄISCHE PATENTANMELDUNG

(21) Anmeldenummer: **91120729.8**

(51) Int. Cl.5: **H01J 37/32, C23C 14/32**

(22) Anmeldetag: **03.12.91**

(30) Priorität: **06.12.90 DE 4038984**

(43) Veröffentlichungstag der Anmeldung:
**10.06.92 Patentblatt 92/24**

(84) Benannte Vertragsstaaten:
**AT BE CH DE DK ES FR GB GR IT LI LU NL SE**

(71) Anmelder: **Multi-Arc Oberflächentechnik GmbH**
**Friedrich-Ebert-Strasse**
**W-5060 Bergisch Gladbach 1(DE)**
Anmelder: **GESELLSCHAFT FÜR ELEKTROMETALLURGIE mbH**
**Höfener Strasse 45**
**W-8500 Nürnberg 80(DE)**

(72) Erfinder: **Dederichs, Hans-Gert**
**Wichheimer Strasse 290**
**W-5000 Köln 80(DE)**

Erfinder: **Burgmer, Wolfgang**
**Blumenstrasse 18**
**W-5000 Köln(DE)**
Erfinder: **Kalb, Werner**
**Flurstrasse 14**
**W-8560 Lauf(DE)**
Erfinder: **van Osten, Karl Uwe**
**Philipp-Kittler-Strasse 20**
**W-8500 Nürnberg(DE)**
Erfinder: **Vogler, Helmut**
**Nordring 11**
**W-8560 Lauf(DE)**

(74) Vertreter: **Patentanwälte Dipl.-Ing. Alex Stenger Dipl.-Ing. Wolfram Watzke Dipl.-Ing. Heinz J. Ring**
**Kaiser-Friedrich-Ring 70**
**W-4000 Düsseldorf 11(DE)**

(54) **Segmentierte Kathode für Lichtbogenbeschichtungsverfahren.**

(57) Eine aus aneinandergefügten, aus unterschiedlichen Werkstoffen bestehenden Segmenten (11, 12) zusammengesetzte Kathode (1) für ein Lichtbogenbeschichtungsverfahren wird dadurch verbessert, daß die Segmente nicht stumpf aneinanderstoßen, sondern entlang Trennlinien (3), die stufenförmig oder keilförmig verlaufen. Die Tendenz eines magnetisch gesteuerten Lichtbogens, an der Trennlinie (3) für einen gewissen Zeitraum "hängenzubleiben" und so zu einem ungleichmäßigen Abtrag der Kathode zu führen, wird hiermit unterbunden.

FIG 1

FIG 2

Die vorliegende Erfindung betrifft eine in einem Lichtbogenbeschichtungsverfahren verzehrbare, aus Segmenten unterschiedlicher Werkstoffe entlang Trennlinien zusammengesetzte Kathode. Dabei sind unter "Segmenten" Unterteilungen von flächigen, meist runden oder rechteckigen Kathoden in einer Vielzahl von Formen zu verstehen, wobei die Kathodenoberfläche vorzugsweise in Form von Kreissektoren ("Tortenstücken") unterteilt ist oder aber in Flächen, die ihrerseits von anderen Flächen ringförmig umgeben sind.

Beim Lichtbogenbeschichtungsverfahren wird durch einen auf der Kathode brennenden Lichtbogen das Material derselben (z. B. Titan) in den Plasmazustand überführt und mit einer gezielt eingestellten Atmosphäre (z. B. aus Stickstoff) reagiert, so daß sich das daraus ergebende Reaktionsprodukt (in diesem Falle Titannitrid) auf den dafür bestimmten Gegenständen (den sogenannten Substraten) in Form einer wenige $\mu$ dicken Schicht niederschlägt. Diese Technik ist dahingehend weiterentwickelt worden (US-A-4 673 477), daß durch den gezielten Einsatz magnetischer Kräfte dem an sich regellos über die Kathodenfläche wandernden Fußpunkt des Lichtbogens eine bestimmte, z. B. kreis- oder spiralförmige Bahn aufgezwungen wird; in erster Linie wird so ein gleichmäßigerer Abtrag der Kathode erreicht. Zugleich ergibt sich die Möglichkeit, den Aufbau von zu bestimmten Zwecken erwünschten Beschichtungen, die bislang nur unter Schwierigkeiten durch den Einsatz mehrerer, gegebenenfalls zeitlich zueinander versetzt betriebener Kathoden erzielbar waren zu vereinfachen, indem der Lichtbogen nacheinander oder auch gleichzeitig über Bereiche der Kathode geführt wird, die aus verschiedenen Materialien bestehen. Auf diese Art und Weise lassen sich sowohl legierte Schichten als auch solche herstellen, die aus mehreren unterschiedlichen Einzelschichten bestehen oder die einen gradierten Übergang zwischen Schichtbereichen der einen oder anderen Zusammensetzung aufweisen.

Es hat sich nun gezeigt, daß der Lichtbogen die Tendenz hat, an der Trennlinie zwischen den einzelnen Segmenten sich in seiner Bewegung zu verzögern, in der Fuge zwischen den Segmenten zu brennen und erst nach einem bestimmten Zeitraum, dann allerdings mit erhöhter Geschwindigkeit weiterzuwandern; dies auch dann, wenn die einzelnen Segmente so gut aneinandergefügt sind, daß keine sichtbare Fuge vorhanden ist. Als Folge tritt ein erhöhter Abbrand im Bereich der Trennlinie auf, der unter Umständen auch dazu führt, daß sich die Kathode von ihrer Unterlage (an der sie zum besseren Wärmeübergang angelötet ist) löst und so vorzeitig unbrauchbar wird. Eine weitere Folge des lokal verstärkten Abbrandes ist eine Verkürzung der Lebensdauer dadurch, daß die Kathode an der Fuge zwischen den Segmenten in ihrer gesamten Stärke abgetragen wird und somit vorzeitig nicht mehr verwendbar ist.

Aufgabe der vorliegenden Erfindung ist eine Verbesserung der bekannten segmentierten Kathoden dahingehend, daß dieser Übelstand beseitigt wird. Dies soll dadurch geschehen, daß die Tendenz des Lichtbogens unterbunden wird, in der Fuge zwischen den einzelnen Segmenten zu brennen.

Die Lösung dieser Aufgabe erfolgt dadurch, daß die segmente an den Trennlinien einander überlappend ausgestaltet sind. Durch die Überlappung wird die Eindringtiefe des Lichtbogens in die unvermeidlicherweise vorhandene Fuge verringert. Der durch die magnetischen Kräfte erzwungenen Wanderung des Lichtbogenfußpunktes stellt sich so ein geringerer Widerstand entgegen.

In der einen speziellen Ausführungsform der Erfindung überlappen die Segmente einander stufenförmig.

In der anderen speziellen Ausführungsform der Erfindung überlappen die Segmente einander keilförmig. Welche der beiden Möglichkeiten zur Anwendung gelangt, wird sich neben der mechanischen Bearbeitbarkeit der einzelnen Werkstoffe vor allem danach richten, wie die einzelnen Segmente geformt sind.

Zwei Ausführungsbeispiele der Erfindung sind in der Zeichnung dargestellt, und zwar im Längsaxialschnitt.

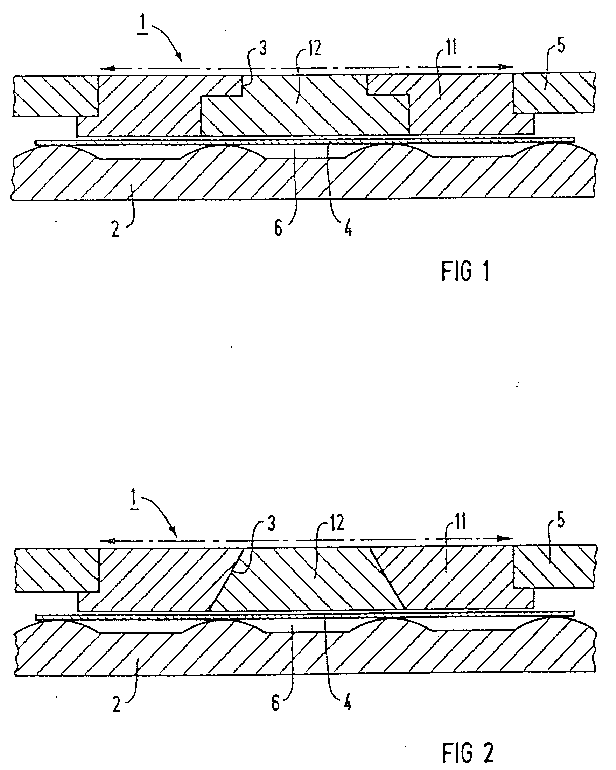

In beiden Fällen wird eine kreisförmige oder rechteckige Kathode 1, die entlang einer Ebene, die senkrecht zur Zeichnungsebene steht in zwei Segmente 11, 12 geteilt. Dabei kann das Segment 11 z. B. aus Titan und das Segment 12 z. B. aus Aluminium bestehen. Die Kathode 1 liegt an einer Unterlage 2, z. B. aus Kupfer an, die Durchflußkanäle 6 für ein Kühlfluid aufweist. Die Kathode 1 wird durch eine hier nur angedeutete Halterung 5 in ihrer Lage gehalten. Für den Wärmeübergang zur Unterlage 2 und zur Abdichtung der Kühlkanäle 6 ist eine verformbare Kupferfolie 4 zwischengelegt. Im Betrieb wird der Lichtbogenfußpunkt entsprechend der strichpunktierten Linie auf der Oberfläche der Kathode hin und her oder im Kreise geführt. Entsprechend wird abwechselnd Titan und Aluminium verdampft, das mit dem Stickstoff der Umgebung reagiert und sich als Aufeinanderfolge von dünnen Titan- bzw. Aluminiumnitridschichten niederschlägt. Bei anderer Aufteilung der Kathode 1 in Segmente 11, 12 und/oder einem veränderten Fahrprogramm für den Lichtbogenfußpunkt können auch Beschichtungen anderer, insbesondere auch gradierter Zusammensetzung hergestellt werden, indem z. B. gleichzeitig Titan und Aluminium verdampft werden. Die einzelnen Segmente 11, 12 der Kathode 1 sind entlang einer Trennlinie 3 gefügt, wobei hier in der Regel keine stoffschlüssige Verbindung möglich sein wird, vielmehr die einzelnen Segmente 11, 12 unter möglichster Vermeidung eines sichtbaren Spaltes aneinanderstoßen. Die Trennlinie 3 kann wie in der Figur 1 gezeigt stufenförmig verlaufen oder aber, wie in der Figur 2 gezeigt, keilförmig, indem abgeschrägte Flächen der Segmente 11, 12 aufeinanderstoßen.

**Patentansprüche**

1.  In einem Lichtbogenbeschichtungsverfahren verzehrbare, aus Segmenten (11, 12) unterschiedlicher Werkstoffe entlang Trennlinien (3) zusammengesetzte Kathode (1), **dadurch gekennzeichnet**, daß die Segmente (11, 12) an den Trennlinien (3) einander überlappend ausgestaltet sind.

2.  Kathode (1) nach Anspruch 1, **dadurch gekennzeichnet**, daß die Segmente (11, 12) einander stufenförmig überlappen.

3.  Kathode (1) nach Anspruch 1, **dadurch gekennzeichnet**, daß die Segmente (11, 12) einander keilförmig überlappen.

FIG 1

FIG 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | WO-A-8 901 699 (REGENTS OF THE UNIVERSITY OF MINNESOTA) <br> * Seite 1, Zeile 4 - Zeile 6 * <br> * Seite 2, Zeile 27 - Seite 3, Zeile 15 * <br> * Seite 8, Zeile 9 - Zeile 15; Abbildung 2 * <br> --- | 1-3 | H01J37/32 <br> C23C14/32 |
| Y | PATENT ABSTRACTS OF JAPAN <br> vol. 7, no. 201 (C-184)(1346) 6. September 1983 <br> & JP-A-58 100 679 ( SHINKUU YAKIN ) 15. Juni 1983 <br> * Zusammenfassung * <br> --- | 1-3 | |
| A | PATENT ABSTRACTS OF JAPAN <br> vol. 13, no. 556 (C-664)(3904) 11. Dezember 1989 <br> & JP-A-01 230 768 ( ASAHI GLASS CO LTD ) 14. September 1989 <br> * Zusammenfassung * <br> --- | 1,3 | |
| A | PATENT ABSTRACTS OF JAPAN <br> vol. 8, no. 93 (C-220)(1530) 27. April 1984 <br> & JP-A-59 009 169 ( RICOH ) 18. Januar 1984 <br> * Zusammenfassung * <br> ----- | 1 | RECHERCHIERTE SACHGEBIETE (Int. Cl.5) <br><br> H01J <br> C23C |

Der vorliegende Recherchenbericht wurde für alle Patentansprüche erstellt

| Recherchenort | Abschlußdatum der Recherche | Prüfer |
|---|---|---|
| DEN HAAG | 09 MAERZ 1992 | GREISER N. |

EPO FORM 1503 03.82 (P0403)